Europäisches Patentamt

(19) European Patent Office

Office européen des brevets

(11) EP 0 723 336 A1

(12) EUROPEAN PATENT APPLICATION

(43) Date of publication:
24.07.1996 Bulletin 1996/30

(51) Int. Cl.⁶: **H03K 5/13**

(21) Application number: 96100768.9

(22) Date of filing: 19.01.1996

(84) Designated Contracting States:
**DE FR GB IT**

(30) Priority: **20.01.1995 DE 19501707**

(71) Applicant: **TEXAS INSTRUMENTS DEUTSCHLAND GMBH
D-85356 Freising (DE)**

(72) Inventors:
• **Elmer, Werner
 D-85368 Moosburg (DE)**
• **Bareither, Jürgen
 D-84184 Tiefenbach (DE)**

(74) Representative: **Schwepfinger, Karl-Heinz, Dipl.-Ing.
 Prinz & Partner,
 Manzingerweg 7
 D-81241 München (DE)**

(54) **An electrical component and a method for matching the internal transit time of such an electrical component**

(57) An electrical component with a basic circuit (12) comprising at least one MOS transistor (N1, P1). The basic circuit (12) is provided with a trim circuit (14) for setting a desired resulting internal transit time, which comprises a plurality of electrically programmable MOS transistor N3, P3, N4, P4, N5, P5 each connected in series with the MOS transistor N1, P1 of the basic circuit 12, such MOS transistors N3, P3, N4, P4, N5, P5 having predetermined gate widths are being able to be set permanently via a respective control gate terminal in a turned on or a turned off state. By performing suitable setting of the resulting gate width of the MOS transistors it is possible to compensate for departures, due to inaccuracies in manufacture, as regards the gate length.

Fig.1

EP 0 723 336 A1

## Description

The invention relates to an electrical component with a basic circuit comprising at least one MOS transistor. It furthermore relates to a method for matching the internal transit time of such an electrical component.

In numerous cases of application in electronics clock and/or clock distribution circuits are necessary. More particularly in microprocessor systems with clock frequencies of 66 MHz and above special clock distribution circuits are employed which must meet very high requirements. Frequently several such clock distribution circuits are present in each system. For a reliable function of the individual components and of the entire system the important point is the precision of the respective clock signals and furthermore the relative phase positions between them. Thus for instance in certain applications it is necessary, in a clock distribution circuit or the like, to keep the phase offset between one connection pin of the respective integrated circuit and another as small as possible. Furthermore there is frequently the requirement that the output signal of one circuit be delayed as little as possible in relation to a given input signal in time and that the respective phase offset be set as exactly as possible. On the basis of a changing process factors such as more particularly the gate length of MOS transistors there may however be, owing to inaccuracies due to production conditions, a substantial variation as regards the internal transit time, for this is significant, from one component to another. The connection of external signal circuits for matching the component is undesired owing to the requirement for economy in space, which is only to be realized if as far as possible all components are accommodated in a single integrated circuit. Furthermore the connection of external matching circuits as a rule involves matching using mechanical operations, something which is relatively slow and accordingly also undesired.

One object of the invention is to provide an electrical component of the type initially mentioned, which may be manufactured in the form of an integrated circuit and as regards its internal transit time may be adjusted, in a simple fashion by the mere application of electrical signals, to a desired value if required. Furthermore a method is to be provided for the matching of the internal transit time of such a component with whose aid any necessary matching may be performed in the simplest and most reliable fashion.

In accordance with the invention this aim is to be achieved as regards the electrical component since the basic circuit is provided with a trim circuit for setting a desired resulting internal transit time, which circuit comprises a plurality of electrically programmable MOS transistor connected respectively in series with the MOS transistor of the basic circuit, such programmable MOS transistors having a predetermined gate width and being able to be permanently set in a turned on or turned off condition via a respective control gate terminal.

Owing to this design it is possible for the basic circuit and furthermore the trim circuit associated with the same of the electrical component to be jointly integrated on one semiconductor substrate. For any necessary matching of the internal transit time of the electrical component it is sufficient to apply corresponding electrical signals, by which the MOS transistor having the respective electrically programmable, predetermined gate widths may be switched into the turned on or turned off state. In this respect the invention is more particularly based on the principle that as regards the drain current and accordingly the internal transit time of MOS transistor the gate length is the controlling process variable and a compensation of a departure due to such process variable is possible by means of the gate width, which during the manufacturing process may be simply and reliably controlled.

Preferably, the values of the gate widths of the electrically programmable MOS transistors bear a predetermined relationship to one another, such values of the electrically programmable MOS transistors being binarily weighted.

The invention is more especially applicable for CMOS and BICMOS circuits, the basic circuit of the electrical component preferably comprising a CMOS inverter with two MOS transistors, cooperating in the manner of a push-pull circuit, with different types of conductivity. In this case it is an advantage to provide respectively several, mutually parallel electrically programmable MOS transistors between ground and the CMOS inverter and also between power and the CMOS inverter. Such electrically programmable MOS transistors are preferably able to be programmed in pairs, each pair being formed by an MOS transistor placed on the ground side of the CMOS inverter and an MOS transistor, placed on the power voltage side of the CMOS inverter, of different types of conductivity. In order to set a respective pair of electrically programmable MOS transistors via a common programming terminal in the turned on and, respectively, the turned off state, it is convenient for the gate terminal of one of the two MOS transistors of different types of conductivity to be connected directly via an inverter element with this common programming terminal.

As regards the method the object is attained in accordance with the invention because in the trim circuit all electrically programmable MOS transistors are rendered effective by their being set in the turned on state, the true value of the resulting internal transit time of the electrical component and the departure thereof from a desired value are determined and furthermore a corresponding number of the electrically programmable MOS transistors having predetermined gate widths are set in the turned off state and are accordingly rendered ineffective in order to set a transit time corresponding to the desired value.

Alternatively it is also possible for all electrically programmable MOS transistors in the trim circuit to be rendered ineffective by setting the same in the turned off state, the true value of the resulting internal transit time of the electrical component and its departure from a desired value being determined and a corresponding number of the MOS transistors having a corresponding number of the predetermined gate widths being set in the turned on state and accordingly being effective in order to set a transit time corresponding to the desired value.

The invention will now be explained in more detail with reference to one embodiment thereof and to the drawings.

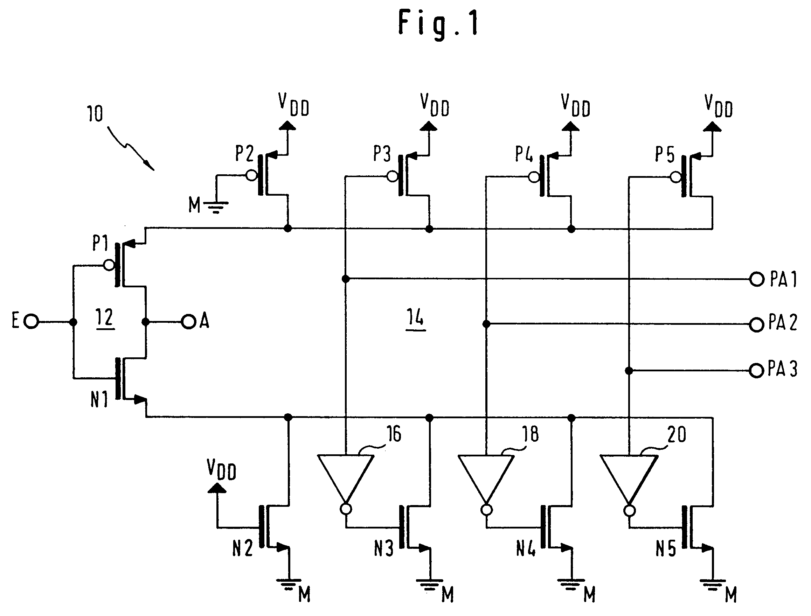

Figure 1      is a diagrammatic circuit diagram of an integrated electrical component which is able to be matched as regards its internal transit time.

Figure 2      shows a clock driver circuit with two matchable components of the type depicted in figure 1.

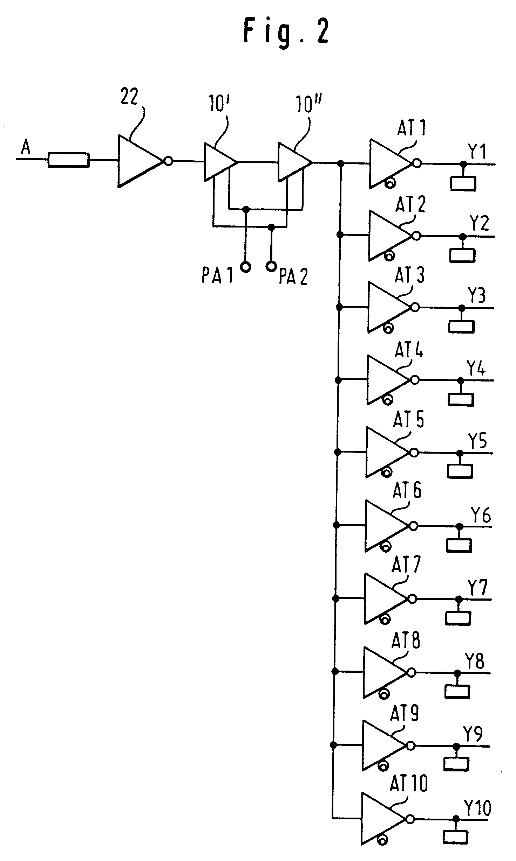

In the case of the electrical component 10 in the form of an integrated circuit it is a question of an inverter stage having an input E and an output A, which for example may be provided in a clock driver circuit (see figure 2) of a clock distributor or the like.

This electrical component 10 possesses a basic circuit 12 and a trim circuit 14 associated with the same for setting the desired resulting internal transit time of the component 10. All circuit parts of the electrical component 10, which in the present case are electrical components produced using CMOS technology, are integrated on a common semiconductor substrate. Basically, such electrical component 10 may also be produced using BICMOS technology.

The basic circuit is constituted by a CMOS inverter 12 with two MOS transistors N1 and P1, cooperating in the form of a push-pull circuit, of different types of conductivity. In this respect the gate terminals of the n channel MOS transistor N1 and of the p channel MOS transistor P1 are connected with one another and with the input E. The drain terminals, which are connected together, of these two MOS transistors N1 and P1 of different types of conductivity are connected with the output A.

The source terminal of the n channel MOS transistor N1 is connected via an n channel MOS transistor N2, set in the turned on state, with ground M. In order to maintain this MOS transistor N2 in the turned on state, its gate terminal is constantly connected with the power voltage $V_{DD}$.

The source terminal of the p channel MOS transistor P1 is connected, via a p channel MOS transistor P2 set in the turned on state, with power $V_{DD}$. In order to maintain such p channel MOS transistor P2 in the turned on condition, its gate terminal is constantly connected with ground M.

If consequently an L level is applied to the input E of the CMOS inverter 12, the MOS transistor P1 will be turned on whereas the MOS transistor N1 will be turned off. In this case an H level will appear at the output A. But if an H level is applied to the input E of the CMOS inverter 12, the MOS transistor N1 will be turned on whereas the MOS transistor P1 will be turned off. Then in this case an L level will appear at the output A.

The trim circuit 14 associated with the CMOS inverter 12 for setting the desired resulting internal transit time of the inverter stage constituted by the electrical component 10, possesses several electrically programmable MOS transistors N3, P3, N4, P4, N5 and P5, respectively connected in series with the MOS transistors N1 and P1 of the CMOS inverter 12, which have predetermined gate widths and are able to be permanently set via a respectively control gate terminal, in a turned on or a turned off state.

In this respect both between ground M and the CMOS inverter 12 and furthermore between power $V_{DD}$ and the CMOS inverter 12 respectively several mutually parallel MOS transistors N3, N4, N5 and, respectively, P3, P4, P5 are connected which are able to be electrically programmed.

The source terminals of the electrically programmable n channel MOS transistors N3, N4 and N5 are respectively connected with ground, whereas the drain connections thereof are connected with the source terminal of the n channel MOS transistor N1 of the CMOS inverter 12 and the drain terminal of the n channel MOS transistor N2.

The source terminals of the electrically programmable p channel MOS transistors P3, P4, and P5 are respectively connected with power $V_{DD}$, whereas the drain connections thereof are connected with the source terminal of the p channel MOS transistor P1 of the CMOS inverter 12 and the drain terminal of the n channel MOS transistor P2.

The electrically programmable MOS transistors N3, P3, N4, P4, N5, P5 are adapted to be programmed in pairs, each pair N3, P3; N4, P4; N5, P5 being formed by an n channel MOS transistor N3, N4, N5 arranged on the ground side of the CMOS inverter 12 and by p channel MOS transistor P3, P4, P5 arranged on the power side of the CMOS inverter 12.

The pairs N3, P3; N4, P4; N5, P5 of electrically programmable MOS transistors are provided respectively with a programming terminal PA1, PA2, PA3 common to the two respective MOS transistors. In this respect the gate terminal of the respective p channel MOS transistor P3, P4, P5 is directly connected with the common programming terminal PA1, PA2, PA3, whereas the gate terminal of the other n channel MOS transistor N3, N4, N5 is joined via an inverter element 16, 18, 20 with this common programming terminal PA1, PA2, PA3.

If consequently an L level is applied to the programming terminal PA1 common to the two electrically programmable MOS transistors N3, P3, the p channel MOS transistor P3 is directly turned on whereas the n channel MOS transistor N3 is turned on via the inverter element 16. If on the other hand an H level is applied, then such two MOS transistors N3 and P3 will be set in the turned off state.

If an L level is applied to the programming terminal PA2, the two electrically programmable MOS transistors N4, P4 and will be turned on.

An H level applied to the programming terminal PA2 will on the other hand be responsible for such two MOS transistors N4, P4 being set in the turned off state.

If an L level is applied to the programming terminal PA3 the two MOS transistors N5, P5 will be turned on. On the other hand such two transistors will be turned off if there is an H level present at the programming terminal PA3.

The values of the gate widths of the electrically programmable MOS transistors N3, P3, N4, P4, N5, P5 have a predetermined relationship between them, the values of such electrically programmable MOS transistors preferably being binarily weighted. Owing to this binary weighting it is accordingly possible for different overall values of the resulting gate width to be set by providing a suitable action at the programming terminals PA1, PA2, PA3. Basically, it is however possible for another weighting of the individual values of the electrically programmable MOS transistors or MOS transistor pairs N3, P3, N4, P4, N5, P5 to be performed.

Furthermore in addition such electrically programmable MOS transistors N3, P3, N4, P4, N5, P5 are so dimensioned with respect to their gate width that by the contribution thereof to the resulting gate width of the electrical component 10 any inaccuracies, more particularly due to manufacture, in the gate lengths of the MOS transistor of the electrical component 10 may be compensated for. In this respect it is to be taken into account that in the case of a series circuit arrangement with two MOS arrangements with the gate widths w1 and, respectively, w2, the following resulting gate width $w_r$ will be produced:

$$w_r = w_1 * w_2/(w_1 + w_2) \qquad (1)$$

The resulting gate width of the electrical component 10 is accordingly so set by suitably programming the MOS transistors N3, P3, N4, P4, N5, P5 that possible departures in the gate length l of the MOS transistor are compensated for. This gate length l is a preferably the same for all MOS transistors of the integrated circuit. The fact that such departures in the gate length l are able to be compensated by the gate width w, which is able to be controlled during manufacture without any trouble, will be seen from the following relationship, which indicates the drain current controlling for the internal transit time, in an MOS transistor:

$$I_D = k * n * (U_{GS} - U_p)^2 \qquad (2)$$

wherein:

k = process constant
n = w/l (gate width/gate length)

$U_{GS}$ = gate source voltage
$U_p$ = threshold voltage
w = gate width of the MOS transistor able to be readily controlled in the process
l = gate length of the MOS transistor, which as regards the internal transit time represents the essential process variable..

If accordingly the expression w/l is maintained essentially constant, it is then possible for manufacturing inaccuracies as regards the gate length l to be completely compensated for so that the drain current $I_D$ and consequently the internal transit time, which more particularly in the case of CMOS and BICMOS circuits is to a high degree dependent on this drain current of MOS transistors, may be maintained substantially constant.

This compensation of any departure in the significant process variable l by a corresponding setting of the gate width w using the electrically programmable MOS transistors may be performed as indicated in the following detailed account:

During the production of the integrated electrical component 10 all electrically programmable MOS transistors N3, P3, N4, P4, N5, P5 of the trim circuit 14 are rendered effective by putting the same in the turned on state. After this the true value of the resulting internal transit time of the electrical component 10 and the departure thereof from a desired value are to be determined. Finally a corresponding number of the programmable MOS transistors N3, P3, N4, P4, N5, P5, which possess a corresponding number of the predetermined gate widths, are set in the turned off state and accordingly rendered ineffective in order to set the transit time corresponding to the desired value.

Alternatively it is possible for firstly all electrically programmable MOS transistors N3, P3, N4, P4, N5, P5 of the trim circuit 14 to be rendered ineffective by setting same in the turned off state. Then the true value of the resulting internal transit time of the electrical component 10 and the departure thereof from a desired value are to be determined. Finally a corresponding number of the electrically programmable MOS transistors N3, P3, N4, P4, N5, P5 having predetermined gate widths are set in the turned on state and consequently rendered ineffective in order to set the transit time corresponding to the desired value.

In either case it was initially assumed that the resulting transit time, which applies when all electrically programmable MOS transistors are turned on, is larger than the desired transit time. The more MOS transistors are rendered ineffective in the course of programming, i. e. turned off, the smaller the resulting transit time which is produced.

Programming may be performed during production of the semiconductor circuit or only when the final testing thereof is performed. It may for example be performed using safety elements, fuses and/or by laser cutting.

## Claims

1. An electrical component comprising a basic circuit (12) with at least one MOS transistor (N1, P1), characterized in that the basic circuit (12) is provided with a trim circuit (14) for setting a desired resulting internal transit time, same comprising a plurality of electrically programmable MOS transistors (N3, P3, N4, P4, N5, P5) respectively connected in series with the MOS transistor (N1, P1) of the basic circuit (12), such programmable MOS transistors having a predetermined gate width and being able to be permanently set in a turned on or turned off condition via a respective control gate terminal.

2. The electrical component as claimed in claim 1, characterized in that the values of the gate widths of the electrical programmable MOS transistors (N3, P3, N4, P4, N5, P5) bear a predetermined relationship to one another.

3. The electrical component as claimed in claim 2, characterized in that the values of the electrically programmable MOS transistors (N3, P3, N4, P4, N5, P5) are binarily weighted.

4. The electrical component as claimed in any one of the preceding claims, characterized in that same is CMOS or BICMOS component.

5. The electrical component as claimed in claim 4, characterized in that the basic circuit comprises a CMOS inverter (12) with two MOS transistors (N1, P1) with different types of conductivity and cooperating together in the manner of a push-pull circuit.

6. The electrical component as claimed in claim 5, characterized in that both between ground (M) and the CMOS inverter (12) and also between power (V_{DD}) and the CMOS inverter (12), respectively, several mutually parallel electrically programmable MOS transistors (N3, N4, N5; P3, P4, P5) are connected.

7. The electrical component as claimed in claim 6, characterized in the electrically programmable MOS transistors (N3, P3, N4, P4, N5, P5) are able to be programmed in pairs, each pair (N3, P3; N4, P4; N5, P5) being formed by an MOS transistor (N3, N4, N5) connected with the ground side of the CMOS inverter (12) and an MOS transistor (P3, P4, P5) of a different type of conductivity arranged on the power side of the CMOS inverter (12).

8. The electrical component as claimed in claim 7, characterized in that the pairs (N3, P3; N4, P4; N5, P5) of electrically programmable MOS transistors are each associated with a programming terminal (PA1, PA2, PA3) common to the two respective MOS transistors (N3, P3; N4, P4; N5, P5), the gate terminal of one of the two MOS transistors (N3, P3; N4, P4; N5, P5) being connected directly with the common programming terminal (PA1, PA2, PA3) and the gate terminal of the other MOS transistor of a different type of conductivity being connected via an inverter element (16, 18, 20) with the common programming terminal (PA1, PA2, PA3).

9. The electrical component as claimed in any one of the claims 5 through 8, characterized in that the CMOS inverter (12) is respectively connected via a non-programmable MOS transistor (N2, P2) set in a turned on state with ground (M) or, respectively, power (V_{DD}).

10. A method of matching the internal transit time of an electrical component as claimed in any one of the preceding claims, characterized in that in the trim circuit (14) all electrically programmable MOS transistors (N3, P3, N4, P4, N5, P5) are rendered effective by being set in the turned on state, in that the true value of the resulting internal transit time of the electrical component and its departure from a desired check valve are determined and in that a corresponding number of MOS transistors (N3, P3, N4, P4, N5, P5) having predetermined gate widths are set in the turned off state and accordingly are rendered ineffective in order to set a transit time corresponding to the desired value.

11. A method of matching the internal transit time of an electrical component as claimed in any one of the claims 1 through 9, characterized in that in the trim circuit (14) all electrically programmable MOS transistors (N3, P3, N4, P4, N4, P5) are rendered ineffective, because they are set in the turned off state, in that the true value of the resulting internal transit time of the electrical component and its departure from a desired value are determined and in that a corresponding number of electrically programmable MOS transistors (N3, P3, N4, P4, N5, P5) having predetermined gate widths are set in the turned on state and accordingly are rendered effective in order to set a transit time corresponding to the desired value.

Fig.1

# Fig. 2

## EUROPEAN SEARCH REPORT

European Patent Office

Application Number
EP 96 10 0768

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US-A-5 121 014 (HUANG) 9 June 1992<br>* column 2, line 8 - column 3, line 11 *<br>* figures 1,2 *<br>--- | 1-11 | H03K5/13 |
| X | WO-A-88 08642 (NCR CORPORATION ) 3 November 1988<br>* the whole document *<br>--- | 1,2,4,5,9 | |
| A | IEEE JOURNAL OF SOLID-STATE CIRCUITS, vol. 27, no. 8, 1 August 1992, pages 1176-1185, XP000309397<br>GABARA T J ET AL: "DIGITALLY ADJUSTABLE RESISTORS IN CMOS FOR HIGH-PERFORMANCE APPLICATIONS"<br>* page 1177, left-hand column, paragraph A; figure 2 *<br>--- | 3 | |
| P,X | EP-A-0 637 134 (SGS-THOMSON MICROELECTRONICS, INC.) 1 February 1995<br>* column 3, line 10 - column 4, line 56 *<br>* figure 2 *<br>----- | 1,2,4-7,9-11 | |
| | | | TECHNICAL FIELDS SEARCHED (Int.Cl.6)<br><br>H03K |

The present search report has been drawn up for all claims

| Place of search | Date of completion of the search | Examiner |
|---|---|---|
| THE HAGUE | 3 May 1996 | Jepsen, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)